# EUROPÄISCHE PATENTSCHRIFT

(11) **EP 4 010 625 B1**
(45) Veröffentlichungstag und Bekanntmachung des Hinweises auf die Patenterteilung: **04.06.2025**
(21) Anmeldenummer: 20757230.6
(22) Anmeldetag: 04.08.2020
(51) Int. Cl.: F21S 4/22, F21V 5/00, F21V 7/00, H05K 1/00, F21Y 115/10

(54) **LEUCHTFOLIE MIT MIKROOPTISCHER STRUKTUR**
LUMINOUS FILM HAVING MICROOPTICAL STRUCTURE
FILM LUMINEUX AYANT UNE STRUCTURE MICROOPTIQUE

(30) Priorität: 05.08.2019 DE 102019211703
(43) Veröffentlichungstag der Anmeldung: 15.06.2022
(73) Patentinhaber: LightnTec GmbH, 76135 Karlsruhe (DE)
(72) Erfinder: NEHRHOFF VON HOLDERBERG, Lutz, 76227 Karlsruhe (DE); KALL, Florian, 76137 Karlsruhe (DE)
(74) Vertreter: Kohler Schmid Möbus Patentanwälte
(86) Internationale Anmeldenummer: PCT/EP2020/071906
(87) Internationale Veröffentlichungsnummer: WO 2021/023743

(56) Entgegenhaltungen:
- WO-A1-2014/155237
- WO-A1-2015/176972
- WO-A1-2016/131819
- WO-A2-2011/114263
- FR-A1- 2 992 401
- US-A1- 2013 026 504
- US-A1- 2017 254 518
- US-A1- 2018 245 754

## Beschreibung

### Hintergrund der Erfindung

Die Erfindung betrifft eine mehrlagige Leuchtfolie mit mehreren Leuchtdioden, einer Leiterbahnenlage zur elektrischen Verbindung der Leuchtdioden und einer Trägerlage wie sie aus dem Stand der Technik hinlänglich bekannt ist.

Leuchtfolien sind beispielsweise aus der US 2018/0245754 A1, der WO 2015/176972 A1, der WO 2011/114263 A1, der WO 2014/155237 A1, der WO 2016/131819 A1, der FR 2 992 401 A1 und der US 2017/0254518 A1 bekannt geworden.

Herkömmliche Leuchtfolien werden durch Besatz eines flexiblen Trägermaterials mit Leuchtdioden hergestellt. Die gleichmäßige Ausleuchtung der Folien hängt dabei maßgeblich von der Anzahl der auf dem Trägermaterial befindlichen Leuchtdioden und deren Abständen untereinander ab. Das Maß für den Besatz des Trägermaterials mit Leuchtdioden ist der Füllfaktor. Soll eine höchstmögliche Gleichmäßigkeit in der Lichtabstrahlung erreicht werden, führt dies entweder zu einem größtmöglichen Füllfaktor, also einer sehr großen Anzahl an Leuchtdioden und sehr geringen Abständen zwischen den Leuchtdioden oder zu zusätzlichen diffus lichtdurchlässigen Schichten, die das in den Diffusor eintretende Licht streuen.

Während das Erhöhen der Leuchtdiodenanzahl die elektrische Leistungsaufnahme der Leuchtfolie und damit die thermischen Belastungen erhöht, führen zusätzlich angebrachte Diffusorschichten zu einer starken Erhöhung der Foliendicke sowie zu einer Abschwächung der Leuchtstärke. Üblicherweise werden daher beide Lösungswege kombiniert angewandt, was jedoch keine zufriedenstellenden Resultate ergibt.

Beide üblichen Lösungen führen zu erhöhten Fertigungskosten sowie zu einer gesteigerten Leistungsaufnahme der Folie. Zudem besteht ein weiterer Nachteil herkömmlicher Leuchtfolien mit einer großen Anzahl an Leuchtdioden in der Umsetzung von damit verbundenen Maßnahmen zur Kühlung der Leuchtfolie, was wiederum zur Verringerung der Folienformbarkeit führt. Der nachteilige Effekt reduzierter Folienformbarkeit tritt ebenfalls in Verbindung mit dicken Diffusorschichten, die bis zu sieben Zentimeter betragen können, umso verstärkter ein und kann zur kompletten Versteifung der Folie führen. Mitunter werden Diffusorschichten daher erst nach der Positionierung der Leuchtfolien angebracht.

### Aufgabe der Erfindung

Es ist Aufgabe der Erfindung, eine Leuchtfolie bereitzustellen, die mit einem geringen Füllfaktor, also einer geringen Dichte an Leuchtdioden sowie einer geringen Folienstärke eine gute Verformbarkeit und dabei eine verlustarme homogene Ausleuchtung der Leuchtfolie ermöglicht.

### Beschreibung der Erfindung

Diese Aufgabe wird erfindungsgemäß gelöst durch eine Leuchtfolie gemäß Anspruch 1. Die abhängigen Ansprüche geben bevorzugte Ausgestaltungen wieder.

Die erfindungsgemäße mikrooptische Lage weist mikrooptische Bauelemente auf, die zur Lenkung des in die mikrooptische Lage eingeleiteten Lichts Linsen-, Prismen-, Polarisator-, Filter-, Phasenplatten-, Spiegel-, Blenden-, Gitterstrukturen, Fasern und/oder Lichtleiter aufweisen. Die mikrooptischen Bauelemente erhalten ihre mikrooptische Funktion durch Formgebung und/oder Änderung der Brechzahl eines optisch gleichmäßigen Ausgangswerkstoffs, insbesondere einer Acrylfolie.

Die Formgebung kann mittels klassischer Verfahren wie Aufschmelzen, Schleifen, Ziehen, Ätzen, Pressen und/oder Polieren erfolgen. Die Aufzählung soll hinsichtlich der genannten Verfahren nicht abschließend verstanden werden.

Die mikrooptische Lage lenkt unter Verwendung der mikrooptischen Bauelemente, insbesondere durch Anordnung einer Vielzahl mikrooptischer Strukturen, das in die mikrooptische Lage eingeleitete Licht über festgelegte optische Pfade. Ein optischer Pfad legt dabei den Austrittspunkt und Austrittswinkel eines Lichtstrahls in Abhängigkeit des Eintrittspunkts und des Eintrittswinkels fest. Der Unterschied zu einem gewöhnlichen Diffusor liegt dabei in der inhomogenen Strahlenführung durch die optische Lage, während einen Diffusor ein homogener Strahlengang charakterisiert.

Hierzu weist die mikrooptische Lage eine strukturierte Oberfläche mit sich widerholenden mikrooptischen Bereichen auf. Die mikrooptischen Bereiche dienen zur Umlenkung des unter verschiedenen Winkeln in die mikrooptische Lage eingeleiteten Lichts. Die mikrooptischen Bereiche sind, ausgehend von einem optischen Zentrum, welches genau über einer Leuchtdiode liegt, überwiegend rotationssymmetrisch, insbesondere kreisförmig und/oder elliptisch, ausgebildet. Die mikrooptischen Bereiche weisen eine größere Fläche als die Leuchtdioden auf.

Die Abmessungen der mikrooptischen Bereiche sind an den Leuchtdiodenabstand angepasst und können in den Erstreckungsrichtungen der mikrooptischen Lage unterschiedlich sein. Insbesondere entsprechen die mikrooptischen Bereiche in ihrem richtungsabhängigen Maß mindestens dem Leuchtdiodenabstand in dieser Erstreckungsrichtung der mikrooptischen Lage. Hierdurch kann gewährleistet werden, dass zumindest bis zu einem halben Leuchtdiodenabstand das von den Leuchtdioden abgestrahlte Licht zuverlässig umgelenkt wird.

Besonders effektiv wird das von den Leuchtdioden abgestrahlte Licht genutzt, da die benachbarten mikrooptischen Bereiche überlappen. Hierdurch kann Licht unter sehr großen Abstrahlwinkeln genutzt werden.

Die mikrooptische Lage kann aus Glas, Quarzglas, Polymeren, insbesondere Acryl, und/oder Silicium bestehen. Ebenfalls denkbar ist die Verwendung von Kristallen. Durch Verwendung von Polymeren können die Kosten für die Herstellung der mikrooptischen Lage besonders vorteilhaft gesenkt werden.

Der Begriff Leuchtdiode wird hier stellvertretend für alle lichtemittierenden Dioden, Diodenmodule, Diodenbausteine (Dies) usw. verwendet. Dem Fachmann ist bewusst, dass die Verwendung von spezielleren Leuchtdiodenbausteinen zu Modifikationen der erfindungsgemäßen Leuchtfolie führt kann. Ebenfalls werden unter dem Begriff der Leuchtdiode alle Farben von Leuchtdioden sowie kombinierte Farben in Leuchtdiodenbausteinen verstanden.

### Bevorzugte Ausführungsformen und Weiterbildungen

Bevorzugt ist eine Ausführungsform, bei der die Folie an der lichtabstrahlenden Folienoberfläche eine textile Lage oder eine Vlieslage aufweist. Eine textile Lage oder Vlieslage ermöglicht eine besonders homogene Ausleuchtung der Leuchtfolie und weist zudem akustische Vorteile auf.

Eine bevorzugte Weiterbildung sieht vor, dass die textile Lage oder die Vlieslage durch Beflockung der Folie ausgebildet ist. Mittels Beflockung lässt sich die textile Lage oder die Vlieslage besonders einfach und kostengünstig bereits während der Fertigung der Folie herstellen. Ebenso ist denkbar, die Beflockung erst zu einem späteren Zeitpunkt nach Fertigung der Folie, beispielweise nach Montage der Folie aufzubringen. Hierdurch kann die textile Lage oder Vlies besonders gut vor Beschädigungen geschützt werden.

In einer besonders bevorzugten Weiterbildung besteht die Beflockung aus einem Mischgranulat unterschiedlichster Granulatkörper und/oder Fasern. Hierdurch lässt sich besonders vorteilhaft eine unregelmäßige Ausbildung der Beflockung realisieren, was eine besonders hohe Schallabsorption der Leuchtfolie begünstigt. Alternativ oder zusätzlicher kann das Granulat aus lichtdurchlässigen, insbesondere transparenten, Granulatkörpern und/oder Fasern bestehen, wodurch die Ausleuchtung der Folie ebenfalls verbessert werden kann.

Alternativ oder zusätzlich zu einer textilen Lage, einem Vlies und/oder einem Gewebe kann eine oberseitige Schicht, insbesondere ein Silikatputz, Flüssigtapete, anti-bakterielle und/oder eine anti-haftende Schicht vorgesehen sein.

Weiterhin bevorzugt ist eine Ausführungsform, bei der die erste mikrooptische Lage die Leuchtdioden überwiegend, insbesondere vollständig, umschließt. Hierdurch kann das von den Leuchtdioden abgestrahlte Licht besonders effektiv durch die mikrooptische Lage gelenkt, der Lichtverlust gesenkt und die Gleichmäßigkeit der Ausleuchtung der Folie weiter erhöht werden.

Die mikrooptische Lage ist vorzugsweise in Form einer gestempelten und/oder gepressten Lage ausgebildet. Alternativ oder zusätzlich dazu kann die mikrooptische Lage einstückig ausgebildet sein. Die mikrooptischen Bauelemente können in Form einer planaren, integrierten Optik der mikrooptischen Lage ausgebildet sein.

In einer bevorzugten Ausführungsform, weist die Folie eine Spiegellage auf, die sich in Abstrahlrichtung der Folie hinter den Leuchtdioden befindet. Eine derartige Spiegellage reflektiert, gegen die Leuchtrichtung der Leuchtfolie abgestrahltes Licht und gewährleistet eine noch effektivere und verlustärmere Nutzung des abgestrahlten Lichts der Leuchtdioden.

In einer besonders bevorzugten Ausführungsform bildet die Spiegellage und die Trägerlage eine gemeinsame Lage. Dies ermöglicht die besonders effektive und kostengünstige Fertigung der Folie, da die Spiegellage bereits bei der Fertigung der Trägerlage entsteht. Hierdurch kann die Spiegellage zudem besonders dünn ausgeführt werden.

Bei Nutzung einer Spiegellage kann die mikrooptische Lage besonders effektiv in Abstrahlrichtung der Leuchtfolie hinter den Leuchtdioden und vor der Spiegellage angeordnet werden. Hierdurch kann der optische Pfad durch die mikrooptische Lage verlängert oder die mikrooptische Lage besonders dünn ausgebildet werden. Das von den Leuchtdioden entgegen der Abstrahlrichtung der Leuchtfolie abgestrahlte Licht wird in diesem Fall zuerst entgegen der Abstrahlrichtung der Leuchtfolie durch die mikrooptische Lage bis zu der Spiegellage gelenkt. Die Spiegellage reflektiert das ankommende Licht in Richtung der Abstrahlrichtung der Leuchtfolie, wodurch das Licht ein weiteres Mal durch die mikrooptische Lage gelenkt wird, um schließlich an der Oberfläche der Leuchtfolie auszutreten. Hierdurch wird die Effektivität der Lichtlenkung durch die mikrooptische Lage sowie der Anteil des genutzten Lichts weiter gesteigert.

Bevorzugt ist eine Ausführungsform, bei der die Folie eine weitere mikrooptische Lage mit mikrooptischen Bauelementen aufweist, wobei die Leuchtdioden zwischen den zwei mikrooptischen Lagen angeordnet sind. Hierdurch kann eine effektive Lichtlenkung besonders günstig realisiert werden und der Aufwand der Fertigung kann sich auf die Anordnung der Lagen reduzieren.

Besonders bevorzugt ist eine Ausführungsform, bei der die Trägerlage aus einer Folie, einem Vlies und/oder einem Gewebe, insbesondere einem Textil, besonders bevorzugt einem Papier, besteht. Dies bietet den Vorteil eines breiten Anwendungsbereichs, da die Trägerlage auf die vorherrschenden Bedingungen des Einsatzortes angepasst werden können. In besonderer Weiterbildung kann die Trägerlage lichtdurchlässig, insbesondere vollständig transparent, ausgebildet sein. Hierdurch kann die Leuchtwirkung der Folie beidseitig ausgeführt werden.

Bevorzugt ist weiterhin eine Ausführungsform, bei der die Leiterbahnenlage teilweise lichtdurchlässig, insbesondere vollständig lichtdurchlässig, ausgebildet ist. Die Lichtdurchlässigkeit der Leiterbahnenlage ermöglicht deren Anordnung, in Abstrahlrichtung der Leuchtfolie, vor den Leuchtdioden, ohne dass die Leiterbahnen zur Störung der Leuchtwirkung der Folie führen.

In einer bevorzugten Ausführungsform kann die Leiterbahnenlage aus Kupfer, elektrisch leitender Tinte, Indium-Zinkoxid und/oder Silberoxid bestehen.

Weiterhin bevorzugt ist eine Ausführungsform, bei der die textile Lage oder die Vlieslage unidirektional lichtdurchlässig, insbesondere in Abstrahlrichtung der Folie, ausgerichtet ist. Hierdurch kann die Leuchtwirkung der Leuchtfolie besonders gleichmäßig ausgeführt werden.

Besonders bevorzugt ist eine Ausführungsform, bei der die textile Lage oder die Vlieslage zumindest teilweise akustisch schallhart und/oder schallweich ist. Dies ermöglicht den Einsatz der Leuchtfolie in Bereichen mit akustischen Vorgaben oder zur Verbesserung der akustischen Bedingungen. Je nach Vorgabe kann die textile Lage daher schallabsorbierend und/oder schallreflektierend ausgebildet werden.

Es ist vorgesehen, dass die Leuchtdioden einen Abstand zwischen 8 Millimeter und 100 Millimeter aufweisen.

In besonderer Ausführungsform beträgt der Füllfaktor der Leuchtfolie bei homogener Ausleuchtung zwischen 5 und 50%, insbesondere zwischen 7 und 25%, besonders bevorzugt zwischen 9 und 15%.

Bevorzugt ist eine Ausführungsform, bei der die Foliendicke 0,1 Millimeter bis 40 Millimeter, insbesondere 0,2 Millimeter bis 30 Millimeter, besonders bevorzugt 0,3 Millimeter bis 20 Millimeter, beträgt. Die Dicke der Folie bezieht sich dabei auf die überwiegende Foliendicke ohne Berücksichtigung einer optionalen textilen Lage.

Die Folie ist rollbar, ausgebildet. Dabei beträgt der Biege- und/oder Rollradius zwischen 1 Zentimeter und 10 Zentimeter, besonders bevorzugt zwischen 2 Zentimeter und 5 Zentimeter.

Weiterhin bevorzugt ist eine Ausführungsform, bei der die Steuerung der Leuchtdioden an, insbesondere in, besonders bevorzugt direkt an den Leuchtdioden, der Folie angeordnet ist. Eine derart angeordnete Steuerung vereinfacht die Installation sowie die Lieferung der Leuchtfolie und verringert den benötigten Platz zur Anbringung der Leuchtfolie.

### Detaillierte Beschreibung der Erfindung und Zeichnung

Fig. 1 zeigt eine schematische Ansicht einer ersten Ausführungsform einer nicht beanspruchten Leuchtfolie;
Fig. 2 zeigt eine schematische Ansicht einer zweiten Ausführungsform der erfindungsgemäßen Leuchtfolie;
Fig. 3 zeigt eine schematische Ansicht einer dritten Ausführungsform einer nicht beanspruchten Leuchtfolie.

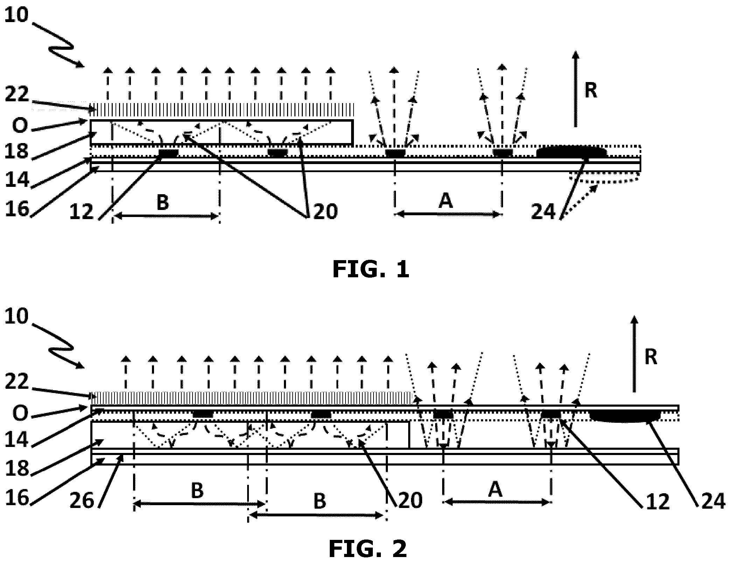

**Fig. 1** zeigt die schematische Seitenansicht einer ersten Ausführungsform einer Leuchtfolie **10** mit mehreren Leuchtdioden **12** (aus Gründen der Übersichtlichkeit wurde lediglich eine Leuchtdiode mit einem Bezugszeichen versehen), einer Leiterbahnenlage **14,** die die Leuchtdioden 12 elektrisch verbindet, eine Trägerlage **16** sowie einer mikrooptischen Lage **18.**

Zur anschaulichen Darstellung der Wirkung durch die mikrooptische Lage 18 zeigt die schematische Darstellung die Leuchtwirkung der Leuchtdioden ohne und mit mikrooptischer Lage 18. Die beiden Leuchtdioden 12, rechts auf der Leiterbahnenlage 14 angeordnet, weisen ein streuendes Lichtbild auf. Ausgehend von den Leuchtdioden 12 wird das Licht mit unterschiedlicher Intensität multidirektional abgestrahlt. Um eine möglichst homogene Ausleuchtung der Leuchtfolie 10 zu erreichen, wird daher im Stand der Technik entweder der Abstand **A** der Leuchtdioden verkleinert oder eine Diffusorschicht (nicht gezeigt) zur Lichtstreuung verwendet.

Auf der linken Seite des schematischen Abbildung wird den Leuchtdioden 12 eine mikrooptische Lage 18 in Abstrahlrichtung **R** der Folie nachgeschalten. Die mikrooptische Lage 18 weist dabei mikrooptische Bauelemente auf, durch die das unidirektional abgestrahlte Licht der Leuchtdioden 12 in die mikrooptische Lage 18 eingekoppelt und auf optischen Pfaden **20** durch die mikrooptische Lage 18 gelenkt wird. Die Ausbildung der mikrooptischen Lage 18 gemäß Fig. 1 führt zu einer überwiegend unidirektionalen Abstrahlung am Austritt des Lichts aus der mikrooptischen Lage 18. Bei gleichem Leuchtdiodenabstand A kann somit eine höhere Homogenität der Ausleuchtung der Leuchtfolie erreicht werden.

Der Leuchtdiodenabstand A entspricht in der Ausführungsform zudem der Breite der mikrooptischen Bereiche **B.** Der mikrooptische Bereich B umfasst den Bereich der mikrooptischen Lage 18, in dem eintretendes Licht über die mikrooptischen Strukturen zur lichtabstrahlenden Oberfläche gelenkt wird. Fig. 1 zeigt nebeneinander liegende mikrooptische Bereiche B.

Die Ausführungsform gemäß Fig. 1 weist zudem an der lichtabstrahlenden Folienoberfläche **O** eine textile Lage / Vlies **22** auf. Die Verwendung einer derartigen textilen Lage / Vlies 22 verbessert die Homogenität der Folienausleuchtung mittels Streuung des abgestrahlten Lichts an der Oberfläche zusätzlich. Zudem kann die Leuchtfolie 10 hinsichtlich akustischer Anforderungen gestaltet werden, was die Einsetzbarkeit der Leuchtfolie 12 weiter erhöht.

Weiterhin weist die Ausführungsform ein Steuergerät **24** auf, welches mit der Leiterbahnenstruktur 14 elektrisch verbunden ist und zur Steuerung der Leuchtdioden 12 dient. Das Steuergerät 24 kann dabei als zentrales Steuergerät 24, wie abgebildet, ausgeführt sein oder mittels einer Reihe von leuchtdiodennahen Steuergeräten dezentral ausgebildet sein. Alternativ oder zusätzlich kann das Steuergerät an der Folienoberfläche, insbesondere an der Trägerlage, angeordnet sein (mit gestrichelten Linien dargestellt).

**Fig. 2** zeigt eine schematische Darstellung einer zweiten Ausführungsform der erfindungsgemäßen Leuchtfolie 10. Die Leuchtfolie 10 weist eine Spiegellage **26** auf, welche entgegen einer Abstrahlrichtung R der Leuchtfolie 10 hinter den Leuchtdioden 12 angeordnet ist. Die mikrooptische Lage 18 ist zwischen den Leuchtdioden 12 und der Spiegellage 18 angeordnet. Das, entgegen der Abstrahlrichtung R der Leuchtfolie 10, abgestrahlte Licht der Leuchtdioden 12 wird dabei entgegen der Abstrahlrichtung R durch die mikrooptische Lage 18 gelenkt und an der Spiegellage 26 reflektiert. Das reflektierte Licht wird dabei in Abstrahlrichtung R umgelenkt und in Abstrahlrichtung R durch die mikrooptische Lage 18 bis zur abstrahlenden Oberfläche O gelenkt. Die lichtabstrahlende Oberfläche O wird hierbei durch eine lichtdurchlässige, insbesondere transparente, Leiterbahnenlage 14 ausgebildet, welche zusätzlich mit einer textilen Lage / Vlies 22 beflockt ist. Hierbei werden, bei ähnlicher Dicke der mikrooptischen Lage wie in Ausführungsform 1 (Fig. 1), die durch die Reflektion an der Spiegellage 26 stark verlängerten optischen Pfade 20 deutlich (aus Gründen der Übersicht wurde nur ein optischer Pfad 20 mit Bezugszeichen versehen).

Zudem zeigt die schematische Darstellung der Leuchtfolie 10 überlappende mikrooptische Bereiche B. Durch Überlappung der mikrooptischen Bereiche B kann besonders effektiv stark streuendes abgestrahltes Licht - welches unter herkömmlichen Umständen als Verlust zählt - dennoch an die lichtabstrahlende Oberfläche O gelenkt werden. Dieser Effekt ist besonders ausgeprägt, wenn die Leuchtdioden 12 von der mikrooptischen Lage 18 umschlossen sind.

Zur Anschauung zeigt das Schema wiederrum den Strahlengang unter Einfluss der mikrooptischen Lage 18 (Leuchtdioden 12 links in der schematischen Darstellung) und ohne deren Einfluss (Leuchtdioden 12 rechts in der schematischen Darstellung).

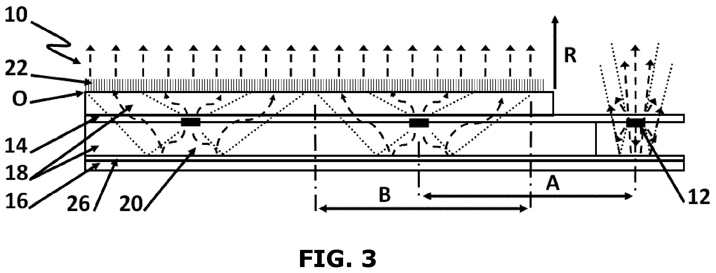

**Fig. 3** zeigt eine schematische Darstellung einer dritten Ausführungsform der Leuchtfolie 10. Die Leuchtfolie 10 weist eine weitere mikrooptische Lage 18 auf. Die Leuchtdioden 12 sowie die Leiterbahnenlage 14 sind zwischen den beiden mikrooptischen Lagen 18 angeordnet. Die Leiterbahnenlage 14 ist lichtdurchlässig, insbesondere transparent, ausgebildet, um die Durchstrahlung nicht zu stören. Die Anordnung der beiden mikrooptischen Lagen 18 ermöglicht die Ausbildung eines breiten mikrooptischen Bereichs B und dementsprechend eine geringe Dichte an Leuchtdioden 12 - verdeutlicht durch den Leuchtdiodenabstand A - bei dennoch homogener Ausleuchtung der Leuchtfolie 10.

Aus der Darstellung der Leuchtfolie 10 in Fig. 3 ist außerdem ersichtlich, dass das abgestrahlte Licht der Leuchtdioden 12 sowohl bei Abstrahlung entgegen der Abstrahlrichtung R der Leuchtfolie als auch bei Abstrahlung in Abstrahlrichtung R der Leuchtfolie 10 oder quer dazu eine Lichtlenkung durch die mikrooptischen Strukturen der mikrooptischen Lagen 18 erfährt.

### Bezugszeichenliste

- 10: Leuchtfolie;
- 12: Leuchtdioden;
- 14: Leiterbahnenlage;
- 16: Trägerlage;
- 18: mikrooptische Lage;
- 20: optische Pfade;
- 22: textile Lage / Vlies;
- 24: Steuergerät;
- 26: Spiegellage;

- A: Abstand der Leuchtdioden;
- B: Breite des mikrooptischen Bereichs;
- O: lichtabstrahlende Folienoberfläche;
- R: Abstrahlrichtung der Leuchtfolie.

## Patentansprüche

1. Mehrlagige Leuchtfolie (10) mit mehreren Leuchtdioden (12), einer Leiterbahnenlage (14) zur elektrischen Verbindung der Leuchtdioden (12) und einer Trägerlage (16), wobei die Leuchtfolie (10) eine mikrooptische Lage (18) mit mikrooptischen Bauelementen zur Erzeugung einer homogenen Ausleuchtung aufweist, wobei die Leuchtdioden (12) einen Abstand (A) zwischen 8 Millimeter und 100 Millimeter aufweisen, wobei die mikrooptische Lage (18) eine strukturierte Oberfläche mit sich wiederholenden mikrooptischen Bereichen (B) aufweist, wobei die mikrooptischen Bereiche (B) ausgehend von einem optischen Zentrum, welches genau über einer Leuchtdiode (12) liegt, überwiegend rotationssymmetrisch ausgebildet sind, wobei die mikrooptischen Bereiche (B) eine größere Fläche aufweisen als die Leuchtdioden (12), wobei die benachbarten mikrooptischen Bereiche (B) überlappen und wobei die Leuchtfolie (10) rollbar ausgebildet ist, wobei der Biege- und/oder Rollradius zwischen 1cm und 10cm beträgt.

2. Leuchtfolie gemäß Anspruch 1, **dadurch gekennzeichnet, dass** die Leuchtfolie (10) an der lichtabstrahlenden Folienoberfläche (O) eine textile Lage oder eine Vlieslage (22) aufweist.

3. Leuchtfolie gemäß Anspruch 2, **dadurch gekennzeichnet, dass** die textile Lage oder die Vlieslage (22) durch Beflockung der Leuchtfolie (10), insbesondere der lichtabstrahlenden Folienoberfläche (O), ausgebildet ist.

4. Leuchtfolie gemäß einem der vorhergehenden Ansprüche, **dadurch gekennzeichnet, dass** die erste mikrooptische Lage (18) die Leuchtdioden (12) überwiegend, insbesondere vollständig, umschließt.

5. Leuchtfolie gemäß einem der vorhergehenden Ansprüche, **dadurch gekennzeichnet, dass** die Leuchtfolie (10) eine Spiegellage (26) aufweist, die sich in Abstrahlrichtung (R) der Leuchtfolie (10) hinter den Leuchtdioden (12) befindet.

6. Leuchtfolie gemäß einem der vorhergehenden Ansprüche, **dadurch gekennzeichnet, dass** die Spiegellage (26) und die Trägerlage (16) eine gemeinsame Lage bilden.

7. Leuchtfolie gemäß einem der vorhergehenden Ansprüche, **dadurch gekennzeichnet, dass** die Leuchtfolie (10) eine weitere mikrooptische Lage (18) mit mikrooptischen Bauelementen aufweist, wobei die Leuchtdioden (12) zwischen den beiden mikrooptischen Lagen (18) angeordnet sind.

8. Leuchtfolie gemäß einem der vorhergehenden Ansprüche, **dadurch gekennzeichnet, dass** die Trägerlage (16) aus einer Folie, einem Vlies und/oder einem Gewebe, insbesondere einem Textil, besonders bevorzugt einem Papier, besteht.

9. Leuchtfolie gemäß einem der vorhergehenden Ansprüche, **dadurch gekennzeichnet, dass** die Leiterbahnenlage (14) teilweise lichtdurchlässig, insbesondere vollständig lichtdurchlässig, ausgebildet ist.

10. Leuchtfolie gemäß einem der vorhergehenden Ansprüche, **dadurch gekennzeichnet, dass** die Leiterbahnenlage (14) aus Kupfer, elektrisch leitender Tinte, Indium-Zinkoxid und/oder Silberoxid besteht.

11. Leuchtfolie gemäß einem der vorhergehenden Ansprüche, **dadurch gekennzeichnet, dass** die textile Lage oder die Vlieslage (22) unidirektional lichtdurchlässig, insbesondere in Abstrahlrichtung (R) der Leuchtfolie (10), ausgerichtet ist.

12. Leuchtfolie gemäß einem der vorhergehenden Ansprüche, **dadurch gekennzeichnet, dass** die textile Lage oder die Vlieslage (22) zumindest teilweise akustisch schallhart und/oder schallweich ist.

13. Leuchtfolie gemäß einem der vorhergehenden Ansprüche, **dadurch gekennzeichnet, dass** die Foliendicke 0,1 Millimeter bis 40 Millimeter, insbesondere 0,2 Millimeter bis 30 Millimeter, besonders bevorzugt 0,3 Millimeter bis 20 Millimeter, beträgt.

## Claims

1. A multilayer luminous film (10) having a plurality of light-emitting diodes (12), a conductor layer (14) for the electrical connection of the light-emitting diodes (12) and a carrier layer (16), the luminous film (10) having a micro-optical layer (18) with micro-optical components for producing homogeneous illumination, the light-emitting diodes (12) having a spacing (A) of between 8 millimeters and 100 millimeters, the microoptical layer (18) having a structured surface having repeating microoptical regions (B), the microoptical regions (B) being predominantly rotationally symmetrical starting from an optical center, which lies precisely above a light-emitting diode (12), the microoptical regions (B) having a larger area than the light-emitting diodes (12), wherein the neighboring microoptical regions (B) overlap and wherein the luminous film (10) is designed to be rollable, the bending and/or rolling radius being between 1 cm and 10 cm.

2. The luminous film according to claim 1, **characterized in that** the luminous film (10) has a textile layer or a fleece layer (22) on the light-emitting film surface (O).

3. The luminous film according to claim 2, **characterized in that** the textile layer or the fleece layer (22) is formed by flocking the luminous film (10), in particular the light-emitting film surface (O).

4. The luminous film according to any of the preceding claims, **characterized in that** the first microoptical layer (18) predominantly, in particular completely, encloses the light-emitting diodes (12).

5. The luminous film according to any of the preceding claims, **characterized in that** the luminous film (10) has a mirror layer (26) that is located behind the light-emitting diodes (12) in the emission direction (R) of the luminous film (10).

6. The luminous film according to any of the preceding claims, **characterized in that** the mirror layer (26) and the carrier layer (16) form a common layer.

7. The luminous film according to any of the preceding claims, **characterized in that** the luminous film (10) has a further microoptical layer (18) having microoptical components, the light-emitting diodes (12) being arranged between the two microoptical layers (18).

8. The luminous film according to any of the preceding claims, **characterized in that** the carrier layer (16) consists of a film, a fleece and/or a woven fabric, in particular a textile, particularly preferably a paper.

9. The luminous film according to any of the preceding claims, **characterized in that** the conductor layer (14) is designed to be partially translucent, in particular completely translucent.

10. The luminous film according to any of the preceding claims, **characterized in that** the conductor layer (14) consists of copper, electrically conductive ink, indium zinc oxide and/or silver oxide.

11. The luminous film according to any of the preceding claims, **characterized in that** the textile layer or the fleece layer (22) is oriented to be unidirectionally translucent, in particular in the emission direction (R) of the luminous film (10).

12. The luminous film according to any of the preceding claims, **characterized in that** the textile layer or the fleece layer (22) is at least in part sonically hard and/or soft.

13. The luminous film according to any of the preceding claims, **characterized in that** the film thickness is 0.1 millimeters to 40 millimeters, in particular 0.2 millimeters to 30 millimeters, particularly preferably 0.3 millimeters to 20 millimeters.

## Revendications

1. Film luminescent multicouche (10) comportant plusieurs diodes électroluminescentes (12), une couche de pistes conductrices (14) pour la connexion électrique des diodes électroluminescentes (12) et une couche de support (16), le film luminescent (10) présentant une couche micro-optique (18) avec des composants micro-optiques pour produire un éclairage homogène, les diodes électroluminescentes (12) étant espacées d'une distance (A) comprise entre 8 millimètres et 100 millimètres, la couche micro-optique (18) présentant une surface structurée avec des zones micro-optiques (B) qui se répètent, les zones micro-optiques (B) étant conçues principalement avec une symétrie de révolution à partir d'un centre optique situé exactement au-dessus d'une diode électroluminescente (12), les zones micro-optiques (B) présentant une surface plus grande que les diodes électroluminescentes (12), les zones micro-optiques (B) voisines se chevauchant et le film luminescent (10) étant conçu pour pouvoir être enroulé, le rayon de courbure et/ou d'enroulement étant compris entre 1 cm et 10 cm.

2. Film luminescent selon la revendication 1, **caractérisé en ce que** le film luminescent (10) présente une couche textile ou une couche de non-tissé (22) sur la surface de film émettrice de lumière (O).

3. Film luminescent selon la revendication 2, **caractérisé en ce que** la couche textile ou la couche de non-tissé (22) est formée par flocage du film luminescent (10), en particulier de la surface de film émettrice de lumière (O).

4. Film luminescent selon l'une des revendications précédentes, **caractérisé en ce que** la première couche micro-optique (18) entoure principalement, en particulier complètement, les diodes électroluminescentes (12).

5. Film luminescent selon l'une des revendications précédentes, **caractérisé en ce que** le film luminescent (10) présente une couche réfléchissante (26) qui se trouve derrière les diodes électroluminescentes (12) dans la direction de rayonnement (R) du film luminescent (10).

6. Film luminescent selon l'une des revendications précédentes, **caractérisé en ce que** la couche réfléchissante (26) et la couche support (16) forment une couche commune.

7. Film luminescent selon l'une des revendications précédentes, **caractérisé en ce que** le film luminescent (10) présente une autre couche micro-optique (18) avec des composants micro-optiques, les diodes électroluminescentes (12) étant disposées entre les deux couches micro-optiques (18).

8. Film luminescent selon l'une des revendications précédentes, **caractérisé en ce que** la couche de support (16) est constituée d'une feuille, d'un non-tissé et/ou d'un tissu, en particulier d'un textile, de préférence d'un papier.

9. Film luminescent selon l'une des revendications précédentes, **caractérisé en ce que** la couche de pistes conductrices (14) est conçue de manière partiellement transparente, en particulier complètement transparente.

10. Film luminescent selon l'une des revendications précédentes, **caractérisé en ce que** la couche de pistes conductrices (14) est constituée de cuivre, d'encre électroconductrice, d'oxyde d'indium et de zinc et/ou d'oxyde d'argent.

11. Film luminescent selon l'une des revendications précédentes, **caractérisé en ce que** la couche textile ou la couche de non-tissé (22) est translucide dans une seule direction, en particulier dans la direction de rayonnement (R) du film luminescent (10).

12. Film luminescent selon l'une des revendications précédentes, **caractérisé en ce que** la couche textile ou la couche de non-tissé (22) est au moins partiellement acoustiquement dure et/ou acoustiquement souple.

13. Film luminescent selon l'une des revendications précédentes, **caractérisé en ce que** l'épaisseur du film est comprise entre 0,1 millimètre et 40 millimètres, en particulier entre 0,2 millimètre et 30 millimètres, de préférence entre 0,3 millimètre et 20 millimètres.
